# EUROPEAN PATENT APPLICATION

(11) **EP 1 050 898 A2**
(43) Date of publication of application: **08.11.2000**
(21) Application number: 00303766.0
(22) Date of filing: 04.05.2000
(51) Int. Cl.: H01L 21/00

(54) **An apparatus and method for aligning a processed wafer for regrinding and/or polishing**

(30) Priority: 04.05.1999 US 304626
(71) Applicant: TSK America, Inc., Oakland, New Jersey 07436 (US)
(72) Inventor: Steere, Robert E., Boonton, New Jersey 07005 (US)
(74) Representative: O'Connell, David Christopher

(57) **Abstract**

The method and apparatus for regrinding the peripheral edge of a wafer employs a pattern recognition (vision) system for determining the position of an alignment pattern on the wafer after being coated or stacked together with one or more other wafers. The vision system is employed in combination with a grinding machine to align the wafer for re-grinding and/or polishing. Infrared light may be used wherein the alignment pattern is hidden from view. Visible light may be used where the alignment pattern is exposed to view.

## Description

This invention relates to an apparatus and method for aligning a processed wafer for regrinding and/or polishing and particularly for regrinding and/or polishing a peripheral edge of the wafer.

As is known, various techniques have been employed for the processing of wafers, such as silicon wafers, in the semi-conductor industry. Typically, wafers are cut from ingots and in some cases, an alignment fiducial or feature such as a "flat" or "v-notch" are present which indicate the crystalline orientation of the wafer. These features are formed into the peripheral edge of the wafer and establish a reference for future processing. One such process step is to grind the edge of the wafer to an exact standard relative to the edge reference. To this end, the wafers are passed through grinding machines in a conventional manner. After edge grinding, the wafers are processed to the "polished wafer" stage at which point they are provided with an alignment pattern marking. The alignment pattern marking relates to and compliments the original edge fiducial alignment to the crystalline orientation. However, during subsequent processing to the polishing and alignment pattern marking, the wafers may be provided with coatings or layers, such as glass, epitaxy or some other layer that is built or grown onto the surfaces of the wafers. Also, in some cases, the wafers are bonded together one on top of another in a stacked manner. Such processes usually distort or re-arrange the edge geometry of the wafer to the extent that a re-grinding of the peripheral edge is required before further processing is undertaken. Re-grinding the peripheral edge contributes significantly to obtaining higher yields and a high quality semi-conductor chip product.

As is known, the visibly rough and distorted edges of coated or layered processed wafers cannot be used to accurately align wafers for re-grinding by conventional edge grinders. This is because the conventional edge grinder techniques for wafer alignment for grinding are based upon the relatively distortion free geometry of as-cut wafers. In the case of wafers which are bonded or stacked on top of each other, misalignments usually exist between the upper and lower wafers thereby resulting in inaccurate alignment by conventional methods.

Accordingly, it is an object of the invention to provide a relatively simple technique to permit the re-grinding the periphery of a processed wafer using a previously applied alignment pattern marking after being coated or after being stacked with other wafers.

Briefly, the invention provides an apparatus and method for aligning a processed wafer for regrinding and/or polishing a peripheral edge of the wafer.

Generally, after wafers are cut from ingots, run through an edge grinding process, and polished, each wafer is provided with an alignment pattern or marking located on a plane parallel to the wafer face for use in applying an etching mask to the wafer. The alignment pattern may be on the top side of the wafer, the bottom side of the wafer, in between the top and bottom sides of the wafer where wafers are stacked or epi-grown over or a combination thereof. This alignment pattern is specifically located with respect to the crystalline orientation of the wafer and establishes a permanent reference point for future use. Thereafter, the wafer is processed in known manner so as to be provided with one or more coatings and/or stacked on another wafer. In any event, this processing of the wafer will so affect the periphery of the wafer that a re-grinding of the peripheral edge of the processed wafer will be required.

The apparatus constructed in accordance with the invention includes a pattern recognition (vision) system for detecting an alignment pattern located on a wafer whether a covered over, i.e. hidden from view pattern or an exposed pattern, and a grind station for grinding and/or polishing a peripheral edge of the wafer in dependence on the location of the detected alignment pattern.

In one embodiment, the pattern recognition system for detecting the alignment pattern on a wafer includes a transmitter for directing light, such as infrared light, onto the plane of the wafer containing a hidden alignment pattern, a receiver for receiving the light which passes through the wafer from the transmitter and a means to identify the alignment pattern from the light received by the receiver. The alignment pattern serves to intercept the infrared light so that the receiver receives the light with the image of the pattern within the received light.

The apparatus may also include an initial station which has a means for rough alignment of the wafer in preparation for the pattern recognition system. This rough alignment may be performed by conventional apparatus and techniques which position a wafer based upon the periphery of the wafer. Alternatively, the pattern recognition system may be constructed to perform both the rough alignment and fine alignment. The system would perform rough alignment by zooming "out" to increase the size of a detectable area. The area would be large enough for the receiver to read the entire surface of the wafer all at once, or the area could cover only a portion of the periphery while the wafer is rotated such that the entire periphery passes through the detectable area, or the area could cover a portion of the wafer face large enough to detect a pattern for rough alignment as the wafer is rotated or held stationary.

Once the rough alignment is complete, the pattern recognition system serves to finely align the wafer.

The fine alignment of the wafer can be performed at the rough alignment station or in a separate fine alignment station or at the grinding station.

The apparatus also employs means to move the wafer after detection of the alignment pattern for fine alignment purposes in the grind station. This means to move the wafer for alignment can employ a combination of rotation and/or linear movements of the wafer. For example, the wafer may be precisely aligned by moving the wafer to a predetermined position and orientation which is the same for all wafers at the fine alignment station or grind station if they are the same. Alternatively, the pattern recognition system may determine the position and orientation of the alignment pattern relative to a reference and the transfer and grind stage motions may then be used to align the wafer for grinding. Still further, the wafer may be oriented by a motion at the fine alignment station but require additional axial motions from the transfer and/or grind station to align the wafer for grinding.

The pattern recognition system for detecting the alignment pattern may employ visible light to look at the near surface of a wafer for pattern recognition or align multiple reference marks which are a distance apart on the wafer using multiple receivers. Different wave lengths of light may also be used to "see" through wafers.

By positioning a light emitter and receiver above and below a wafer, all patterns can be detected when the wave length of light "sees" through the wafer

These and other objects and advantages of the invention will become more apparent from the following detailed description taken in conjunction with the accompanying drawings wherein:
Fig. 1 illustrates a schematic view of one embodiment of an apparatus constructed in accordance with the invention;
Fig. 2 illustrates a schematic view of a modified apparatus having a common rough alignment and fine alignment station in accordance with the invention; and
Fig. 3 illustrates a schematic view of a further modified apparatus having a rough alignment stage and a common fine alignment station and grind stage;
Fig. 4 illustrates a schematic view of a further modified apparatus employing an alignment station, where a vision system performs common rough and fine alignment, with a grind station;
Fig. 5 illustrates a schematic view of a further modified apparatus having a single stage for performing rough alignment, fine alignment and grinding;
Fig. 6 illustrates a view of a modified apparatus having an emitter and receiver on one side of a wafer; and
Fig. 7 illustrates a view of a modified apparatus employing multiple receivers.

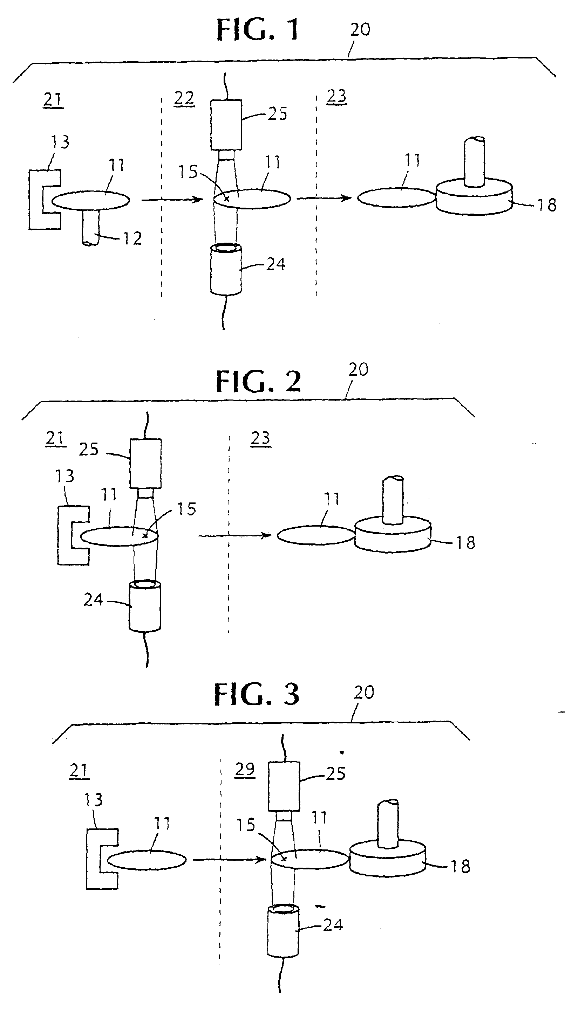

Referring to Fig. 1, after a wafer 11 has been cut from an ingot, the wafer 11 is provided with an alignment mark 15, for example an X to indicate the crystalline orientation of the wafer, on the top surface so as to be located in a plane parallel to the wafer face and in a precise position relative to the crystalline orientation of the wafer 11. The so-marked wafer 11 is delivered to a rough alignment station 21, for example, within a conventional type of edge grinding machine, and placed on a rotatable chuck 12.

The peripheral edge of the wafer 11 is then rotated through a sensing and measuring device 13, such as described in U.S. patent 4,638,601, to determine the geometric center of the wafer 11 in order to perform a rough alignment of the wafer 11.

The wafer 11 is then programmed to move into a grind station 23 in which the periphery of the wafer 11 is ground to a determined shape by a suitable grinding wheel 18. Thereafter, the ground wafer 11 is delivered for further processing in order to be provided with one or more coatings and/or stacked on another wafer. During this processing, the alignment mark 15 is covered over and in some cases hidden from view. Further, because of the processing, it is usually required or desired to have the peripheral edge of the wafer 11 re-ground or polished.

In accordance with the invention, the wafer 11 with the alignment mark 15 is returned to the grinding machine and passed through the rough alignment station 21 as before. Next, the wafer 11 is moved to a fine alignment station 22 where a pattern recognition (vision) system orients the wafer 11 with respect to the alignment mark 15 for travel to the grind station 23.

The pattern recognition system includes an emitter 24 for directing light, such as infrared light, from below onto the plane of the wafer 11 and a receiver 25 for receiving the light passing through the wafer 11 from the transmitter 24. As indicated, the emitter 24 is disposed below the wafer 11 while the receiver 25 is disposed above the wafer. Accordingly, the infrared light from the emitter 24 passes through the wafer 11 onto the receiver 25. Because of the alignment pattern 15, some of the light is intercepted so that an image of the alignment pattern 15 is passed onto the receiver 25

Once the receiver 25 locates the alignment pattern 15, the fine alignment station 22 is able to orient the wafer 11 for transfer to the grind station. This information is then transferred to the means for positioning the wafer in the grind station 23 for regrinding the periphery of the wafer 11 in dependence upon the alignment pattern 15.

Thereafter, the wafer 11 is delivered to the grind station 23 in which the periphery of the wafer is ground to a determined shape by the grinding wheel 18.

The apparatus 20 of the invention thus includes the rough alignment station 21, the fine alignment station 22 and the grind station 23. The rough alignment station 21 is constructed in similar fashion to known alignment stations wherein the wafer can be re-rotated into a predetermined position in dependence upon the location of the geometric center of the wafer.

Referring to Fig. 2, wherein like reference characters indicate like parts as above, the rough alignment and fine alignment functions may also be performed in a common station 26.

Referring to Fig. 3, wherein like reference characters indicate like parts as above, the fine alignment and grinding functions may also be performed in a common station 29.

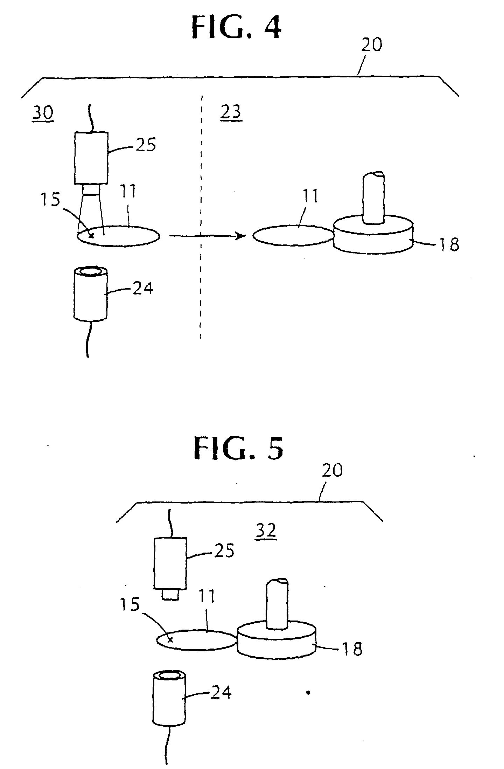

Referring to Fig. 4, wherein like reference characters indicate like parts as above, the rough alignment and the fine alignment functions may also be performed by multi-functional common hardware in the same station 30. For example, for rough alignment purposes, the emitter 24 and receiver 25 may be "zoomed out" so that the entire surface of wafer 11 can be viewed at one time. For fine alignment purposes, the emitter 24 and receiver 25 would be "zoomed in" so that the detectable area of the wafer 11 is only a small portion of the wafer 11. Zooming in also provides for better resolution.

Referring to Fig. 5, wherein like reference characters indicate like part as above, the rough alignment, fine alignment and grinding functions may also be performed in the same station 32.

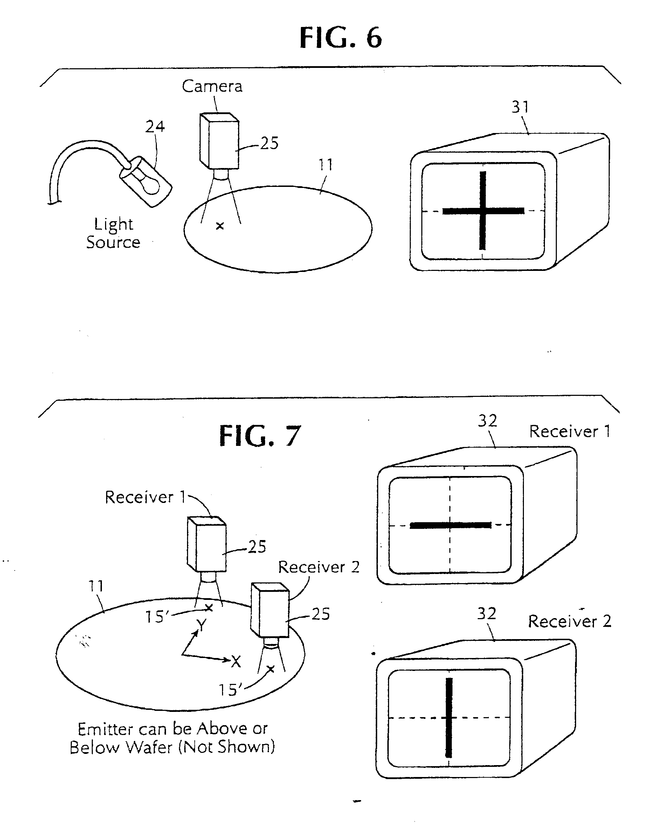

Referring to Fig. 6, wherein like reference characters indicate like parts as above, in another embodiment, for a wafer wherein the alignment mark 15 is exposed to view, the pattern recognition system may have the emitter 24 in the form of a visible light source for directing visible light at a wafer 11 and the receiver 25 in the form of a camera for viewing the illuminated image on the same side of the wafer 11. In addition, the pattern recognition system may employ a display monitor 31 having a screen for displaying the located exposed alignment mark 15. To this end, the pattern recognition system has suitable software to locate and display the alignment mark 15.

Referring to Fig. 7, wherein like reference characters indicate like parts as above, the pattern recognition system may employ a single emitter (not shown) and multiple receivers 25, for example, two separately disposed and spaced apart receivers 25 to align reference marks which together constitute an alignment pattern located in different areas of a wafer 11. The emitter (not shown) used with the multiple receivers 25 may be located above or below the wafer depending on the type of light used. The light source (emitter) may be in the form of a ring which covers the entire area around the periphery of the wafer. In this embodiment, the alignment mark is actually formed by two separately spaced alignment patterns or marks 15', for example 90° apart on the periphery of the wafer 11. Once the marks 15' are properly located, i.e. detected, by the two receivers 25, the marks would be displayed on the viewing screens of the display monitors 32 in proper orientation. Once the wafer has been rotated so that the alignment marks 15' are properly located under the receivers 25, the wafer 11 can be transferred to a grind station, as above, for re-grinding of the periphery or polishing of the periphery of the wafer 11.

The method of aligning a processed wafer with a hidden-from-view alignment mark thus includes an initial step of directing a beam of infrared light onto the wafer from an emitter of infrared light and receiving the beam of infrared light passing through the wafer in a receiver. In accordance with the method, the wafer is positioned in order to locate the alignment mark in the beam of infrared light and sensing an interruption in the beam of infrared light received in the receiver in response to the alignment mark and locating the wafer in dependence on the sensed interruption.

The technique of the invention may also be employed where the alignment can be detected with visible light, for example, using the apparatus of Fig. 6 or of Fig. 7. In this respect, the method of aligning a processed wafer having a exposed alignment mark for re-grinding and/or polishing in a grinding machine simply directs a beam of visible light onto the wafer while receiving light reflected from the wafer in a receiver 25. Next, the wafer is rotated relative to the beam of light in order to locate the alignment mark 15 in alignment with the receiver 25 and sensing an interruption in the beam of light received in the receiver 25 in response to the alignment mark 15 moving into alignment with the receiver 25 and locating the wafer 11 in dependence on the sensed interruption.

## Claims

1. An apparatus for aligning a wafer for rewinding and/or polishing a peripheral edge of a processed wafer, said apparatus comprising a grind station (23) for grinding and/or polishing a peripheral edge of a wafer (11); and characterized in having a pattern recognition system (24, 25) for detecting an alignment mark or pattern (15) disposed in a plane parallel to a face of the wafer (11) and programming said grind station (23) to re-grind and/or polish the wafer in dependence on the location of the detected alignment mark or pattern (15).

2. An apparatus as set forth in claim 2 further characterized in that said pattern recognition system includes an emitter (24) for directing light onto said plane of the wafer, a receiver (25) for receiving the light passing from the wafer and a means to identify said alignment pattern from the light received by said receiver.

3. An apparatus as set forth in claim 2 further characterized in that said emitter (24) and said receiver (25) are disposed on the same side of a wafer (11).

4. An apparatus as set forth in claim 2 further characterized in that said emitter (24) transmits infrared light and said receiver (25) is disposed on an opposite side of a wafer (11) from said emitter (24) to receive infrared light passing through the wafer (11).

5. An apparatus as set forth in claim 1 further characterizes in that said system includes multiple receivers (25) to detect and align reference marks located in different areas of a wafer (11).

6. A method of aligning a processed wafer (11) having a visible or hidden-from-view alignment mark (15) for at least one of regrinding and polishing a peripheral edge thereof, said method characterized in the steps of
directing a beam of infrared light onto the wafer from an emitter (24) of infrared light;
receiving the beam of infrared light passing through the wafer (11) in a receiver (25);
rotating the wafer (11) relative to the beam of infrared light to locate the alignment mark in the beam of infrared light;
sensing an interruption of the beam of infrared light received in the receiver in response to the alignment mark moving into the beam of infrared light and locating the wafer in dependence on the sensed interruption; and
thereafter moving the wafer into a grind station for regrinding or polishing the periphery of the wafer in dependence upon the located alignment mark.

7. A method of aligning a processed wafer (11) having a visible alignment mark (15) for regrinding and/or polishing, said method characterized in the steps of
directing a beam of visible light onto the wafer (11);
receiving the beam of light reflected from the wafer in a receiver (25);
rotating the wafer relative to the beam of light to locate the alignment mark (15) in the beam of light;
sensing an interruption in the beam of light received in the receiver (25) in response to the alignment mark (15) moving into the beam of light and locating the wafer in dependence on the sensed interruption; and
thereafter moving the wafer (11) into a grind station (23) for regrinding and/or polishing the periphery of the wafer (11) in dependence upon the located alignment mark (15).

8. A method of aligning a processed wafer (11) having at least a pair of alignment marks (15) for regrinding and/or polishing, said method characterized in the steps of
directing at least one beam of light onto the wafer (11);
receiving light reflected from the wafer in each of a pair of receivers (25);
rotating the wafer relative to the receivers (25) to locate the alignment marks (15) in alignment with the receivers (25);
sensing an interruption in the light received in the receivers (25) in response to the alignment marks (15) moving into alignment with the receivers (25) and locating the wafer (11) in dependence on the sensed interruptions; and
thereafter moving the wafer (11) into a grind station (23) for regrinding or polishing the periphery of the wafer (11) in dependence upon the located alignment mark (15).
